(19) Europäisches Patentamt
European Patent Office
Office européen des brevets

(11) EP 1 975 952 A2

(12) EUROPEAN PATENT APPLICATION

(43) Date of publication:
01.10.2008 Bulletin 2008/40

(51) Int Cl.:
$H01G$ 9/20 $^{(2006.01)}$

(21) Application number: 08005873.8

(22) Date of filing: 27.03.2008

(84) Designated Contracting States:
AT BE BG CH CY CZ DE DK EE ES FI FR GB GR HR HU IE IS IT LI LT LU LV MC MT NL NO PL PT RO SE SI SK TR
Designated Extension States:
AL BA MK RS

(30) Priority: 29.03.2007 JP 2007086271

(71) Applicant: TDK Corporation
Tokyo 103-8272 (JP)

(72) Inventors:
• Monden, Atsushi
Tokyo 103-8272 (JP)
• Handa, Tokuhiko
Tokyo 103-8272 (JP)

(74) Representative: Grünecker, Kinkeldey, Stockmair & Schwanhäusser
Anwaltssozietät
Leopoldstrasse 4
80802 München (DE)

(54) **Photoelectric conversion electrode, manufacturing method of the same, and dye-sensitized solar cell**

(57) There are disclosed a photoelectric conversion electrode (11) having a large amount of a dye to be supported and an excellent dye replacement property and having a capability of improving a photoelectric conversion efficiency, a manufacturing method of the photoelectric conversion electrode (11) and the like. A photoelectric conversion electrode (11) according to the present invention can be manufactured by laminating a porous metal oxide layer (14) including a metal oxide and a dye on a substrate (12) having a conductive surface (12a), and the metal oxide layer (14) has a specific surface area of 70 to 250 $m^2$/g and a void ratio of 50 to 75%. Specifically, the metal oxide layer (14) can be formed by a cathode electrolytic deposition process using an electrolyte containing a metal salt and 80 to 500 $\mu$M of template dye, the template dye co-adsorbed on the metal oxide layer (14) is desorbed, and a sensitizing dye different from the template dye is more preferably re-adsorbed.

FIG.1

**Description**

BACKGROUND OF THE INVENTION

Field of the Invention

The present invention relates to a photoelectric conversion electrode, a manufacturing method of the photoelectric conversion electrode, and a dye-sensitized solar cell including the photoelectric conversion electrode.

Description of the Related Art

A dye-sensitized solar cell published by Gratzel et al. in 1991 has especially received attention as an organic solar cell capable of realizing a conversion efficiency of 10% or more. In recent years, application, development and research of the solar cell have intensively been performed in various research organizations at home and abroad. This dye-sensitized solar cell has a basic structure in which a redox electrolyte is sandwiched between an electrode and a counter electrode disposed so as to face the electrode. As the electrode, there is used a porous titanium oxide electrode having an adsorbed sensitizing dye and provided on a transparent conductive film of a transparent glass substrate. The titanium oxide electrode is prepared by coating the transparent conductive film with a coating solution in which titanium oxide particles are suspended, and firing the film at a temperature of about 300 to 500°C to allow the resultant film to adsorb the sensitizing dye.

On the other hand, in this type of dye-sensitized solar cell, from an industrial viewpoint of productivity improvement, it has been demanded that an inexpensive and lightweight plastic substrate having flexibility be employed as a member to replace the transparent glass substrate. However, as described above, a high temperature firing process is required for preparing the titanium oxide electrode, so that it has been difficult to employ a plastic substrate having a poor thermal resistance with respect to the glass substrate.

To solve this problem, for example, in Non-Patent Document 1, a dye-sensitized solar cell is suggested in which an electrode constituted of a metal oxide film such as porous zinc oxide is formed of an electrolyte containing a metal salt such as zinc chloride by use of a cathode electrolytic deposition process as a low temperature electrochemical technique, whereby the dye is adsorbed on the electrode. According to this technique, the porous metal oxide electrode can be prepared by performing the cathode electrolytic deposition using the electrolyte, so that the above-mentioned high temperature firing process required for manufacturing the solar cell having the above titanium oxide electrode can be omitted. However, on the other hand, the metal oxide electrode is formed and then allowed to adsorb the dye, so that a sufficient amount of the sensitizing dye cannot be adsorbed by the resultant dye-supported metal oxide electrode. Therefore, the photoelectric conversion efficiency cannot sufficiently be improved.

Therefore, to increase an amount of the dye to be supported in a zinc oxide electrode, for example, in Non-Patent Document 2, a method is suggested in which the cathode electrolytic deposition is performed using a zinc nitrate bath including a water-soluble dye such as eosin-Y beforehand added thereto as a template dye, whereby the water-soluble dye is co-adsorbed to form a hybrid thin film of zinc oxide/eosin-Y. It is disclosed in Patent Document 1 that the cathode electrolytic deposition is performed using a zinc nitrate electrolyte including eosin-Y beforehand added thereto as the template dye, whereby a porous photoelectric conversion semiconductor layer including co-adsorbed eosin-Y and having a specific surface area of 1 to 100 $m^2/g$ is prepared. However, contrary to expectation, the dye-supported zinc oxide electrode prepared by the cathode electrolytic deposition process in this manner has a poor sensitizing function of the co-adsorbed dye typified by eosin-Y, and the photoelectric conversion efficiency of a photoelectric conversion element using the electrode is not sufficient.

Therefore, to introduce a dye having an excellent sensitizing function into the porous zinc oxide electrode, a method is disclosed in Patent Document 2 in which the porous zinc oxide electrode prepared by co-adsorbing eosin-Y onto the surface of zinc oxide by the cathode electrolytic deposition is alkali-treated to once desorb the dye therefrom, and then a highly sensitive sensitizing dye is re-adsorbed. According to this technique, it has been expected that the zinc oxide electrode with a sufficient amount of the highly sensitive sensitizing dye supported thereon can be realized.

[Patent Document 1] Japanese Patent Application Laid-Open No. 2002-184476
[Patent Document 2] Japanese Patent Application Laid-Open No. 2004-006235
[Non-Patent Document 1] S. Peulon et al., J. Electrochem. Soc., 145, 864 (1998)
[Non-Patent Document 2] T. Yoshida et al., Electrochemistry, 70, 470 (2002)

However, in the above-mentioned conventional porous zinc oxide electrode which has co-adsorbed the template dye, it is remarkably difficult to sufficiently desorb the co-adsorbed template dye and re-adsorb the sufficient amount of the sensitizing dye. Therefore, when the porous zinc oxide electrode is used in the dye-sensitized solar cell, a photoelectric conversion efficiency ($\eta$) cannot sufficiently be raised. On the contrary, cell characteristics such as an open-circuit voltage (Voc), a short-circuit photoelectric current density (Jsc) and a fill factor (FF) are insufficient, and a higher performance is demanded so as to put the cell to practical use.

The present invention has been developed in view of such a situation, and an object is to provide a photoelectric conversion electrode including a metal oxide layer having an excellent dye replacement property and a large amount of a dye to be supported and having a capability of improving a photoelectric conversion efficiency, a manufacturing method of the electrode, and a dye-sensitized solar cell.

To solve the above problem, the present inventors have intensively repeated researches, have eventually found that a metal oxide layer having a specific structure especially has an excellent desorption property of a co-adsorbed template dye and an excellent re-adsorption property of a sensitizing dye, and have completed the present invention.

That is, a photoelectric conversion electrode according to the present invention includes, for example, a substrate, and a metal oxide layer formed on the substrate, including a metal oxide and a dye and having a specific surface area of 70 to 250 m$^2$/g and a void ratio of 50 to 75%.

Here, the "specific surface area" is a surface area of a solid sample per unit mass, and is more specifically a value (a BET specific surface area) calculated from the following equation (1) based on a BET nitrogen adsorption isothermal curve.

$$\text{Specific surface area } (m^2/g) = \text{surface area } (m^2)/\text{sample weight } (g) \ ... \ (1)$$

Moreover, the "void ratio" is a ratio (volume percentage) of voids (pores) present per unit mass of the porous solid sample, and is more specifically a value calculated from the following equation (2) based on the constant-volume gas adsorption method.

$$\text{Void ratio } (\%) = [\text{pore volume } (ml/g)/\{1/\text{true density } (g/ml) \text{ of the sample } + \text{pore volume } (ml/g)\}] \times 100 \ ... \ (2)$$

It is to be noted that in the present specification, "including the metal oxide layer on the substrate" includes a configuration in which the metal oxide layer is provided on the substrate via an intermediate layer in addition to a configuration in which the metal oxide layer is directly provided on the substrate. Therefore, a specific configuration of the present invention includes both of a laminated structure in which the substrate directly comes in contact with the metal oxide layer as in the former configuration and a laminated structure in which the substrate is disposed away from the metal oxide layer as in the latter configuration.

As a result of measurement of a characteristic of a dye-sensitized solar cell including a counter electrode disposed so as to face the photoelectric conversion electrode having the above constitution and a charge transport layer provided between both of the electrodes, the present inventors have found that, as compared with a conventional technology, not only a photoelectric conversion efficiency but also any other cell characteristic are remarkably improved. Details of a functional mechanism which produces such an effect are not clarified yet, but are presumed as follows.

That is, it is supposed that the above-mentioned conventional metal oxide layer is a structure including a remarkably dense film structure and not having porosity to such a extent that the dye (molecules) can physically move, so that it has been difficult to efficiently desorb the co-adsorbed template dye and re-adsorb a sensitizing dye. On the other hand, in the present invention, the metal oxide layer is constituted so as to obtain a structure having a specific surface area of 70 to 250 m$^2$/g and a void ratio of 50 to 75%, and having a so-called appropriate porosity to such an extent that the dye can physically move, whereby a dye replacement property is remarkably improved. As a result, an amount of the dye to be supported by the metal oxide layer is increased, and the photoelectric conversion efficiency is significantly increased. Moreover, supposedly owing to a specific structure having the appropriate porosity, cell characteristics such as an open-circuit voltage, a short-circuit photoelectric current density and a fill factor can remarkably be improved. However, the function is not limited to this example.

More specifically, it is preferable that the dye is a sensitizing dye in which a molar absorption coefficient $\varepsilon$ in a

visible light range measured in a t-BuOH/acetonitrile solution is 20000 $mol^{-1}\cdot L\cdot cm^{-1}$ or more, so that the photoelectric conversion efficiency can further be improved.

Furthermore, a dye-sensitized solar cell according to the present invention includes the above photoelectric conversion electrode according to the present invention, a counter electrode disposed so as to face the photoelectric conversion electrode, and a charge transport layer disposed between the photoelectric conversion electrode and the counter electrode.

Moreover, a manufacturing method of a photoelectric conversion electrode according to the present invention is a method for effectively manufacturing the photoelectric conversion electrode according to the present invention, comprising: a step of preparing a substrate; and an electrolytic deposition step of electrolytically depositing a metal oxide and co-adsorbing a template dye by an electrolytic deposition process using an electrolyte containing a metal salt and the template dye to form a porous metal oxide layer on the substrate, wherein the electrolytic deposition step forms the metal oxide layer having a specific surface area of 70 to 250 $m^2/g$ and a void ratio of 50 to 75%.

In addition, it is preferable that the electrolytic deposition step arranges the substrate and a counter electrode in the electrolyte containing 80 to 500 $\mu M$ of template dye so that the substrate faces the counter electrode, and applies an electrolysis potential of -0.8 to -1.2 V (vs. Ag/AgCl) between the substrate and the counter electrode to form the metal oxide layer. Such an electrolyte and electrolysis conditions are used, whereby a photoelectric conversion electrode including the metal oxide layer having an excellent dye replacement property can easily be manufactured with good reproducibility.

Moreover, it is preferable that the method further comprises a dye desorption step of desorbing the template dye co-adsorbed on the metal oxide layer; and a dye re-adsorption step of allowing the metal oxide layer to support a second dye different from the template dye. In this case, even a sensitizing dye difficult to use, depending on the electrolysis conditions of the electrolytic deposition step, can be introduced into the metal oxide layer in the re-adsorption step, so that the availability of materials (process tolerance) can be broadened, and productivity and economical efficiency can further be improved.

Alternatively, a manufacturing method of a photoelectric conversion electrode according to the present invention may be a method in which the electrolytic deposition step electrolytically deposits a metal oxide and co-adsorbs the template dye by the electrolytic deposition process using an electrolyte containing the template dye in excess of 100 $\mu M$, to form the metal oxide layer having a large specific surface area in excess of 100 $m^2/g$. In this case, in the same manner as described above, the step may arrange the substrate and the counter electrode in the electrolyte so that the substrate faces the counter electrode, and apply an electrolysis potential of -0.8 to -1.2 V (vs. Ag/AgCl) between the substrate and the counter electrode. In this case, the metal oxide layer having a specific surface area in excess of 100 $m^2/g$, which has heretofore been difficult to prepare, can easily be manufactured with good reproducibility.

According to the photoelectric conversion electrode, the manufacturing method of the photoelectric conversion electrode and the dye-sensitized solar cell including the photoelectric conversion electrode of the present invention, a dye replacement property can be improved to increase an amount of a dye to be supported, so that when this electrode is used as a photoelectric conversion element, a high photoelectric conversion efficiency can be realized, and cell characteristics such as an open-circuit voltage, a short-circuit photoelectric current density and a fill factor can be improved. Moreover, the porous metal oxide layer can be formed at a low temperature without any high temperature firing process, so that productivity and economical efficiency can be improved. In addition, a plastic substrate or the like having a poor thermal resistance as compared with a glass substrate can be applied as the substrate. Therefore, the availability of materials (process tolerance) can be broadened, and the productivity and economical efficiency can further be improved.

BRIEF DESCRIPTION OF THE DRAWINGS

FIG. 1 is a schematic sectional view schematically showing one embodiment of a photoelectric conversion electrode according to the present invention;

FIGS. 2A to 2C are step diagrams showing one example of a manufacturing method of the photoelectric conversion electrode according to the present invention; and

FIG. 3 is a schematic sectional view schematically showing one embodiment of a dye-sensitized solar cell according to the present invention.

DESCRIPTION OF THE PREFERRED EMBODIMENTS

Embodiments of the present invention will hereinafter be described. It is to be noted that the same element is denoted with the same reference numeral, and redundant description is omitted. Moreover, positional relations of top, bottom, left, right and the like are based on a positional relation shown in the drawings unless otherwise mentioned. Furthermore, a dimensional ratio of the drawing is not limited to a shown ratio. The following embodiments merely illustrate the present invention, and the present invention is not limited only to the embodiments.

(First Embodiment)

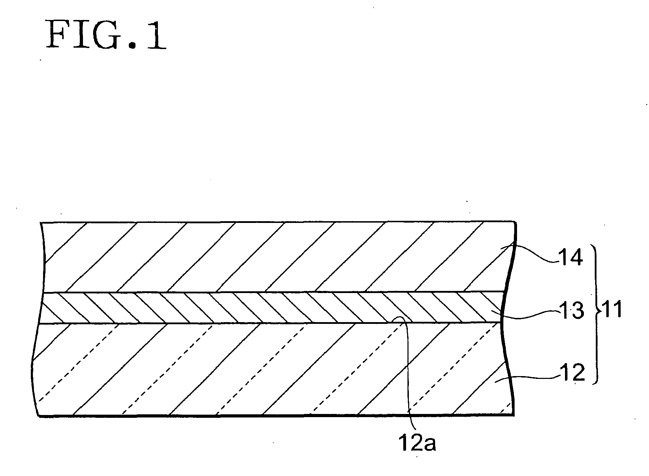

FIG. 1 is a schematic sectional view schematically showing one embodiment of a photoelectric conversion electrode according to the present invention. In a photoelectric conversion electrode 11, a porous metal oxide layer 14 including zinc oxide as a metal oxide and a sensitizing dye (the dye) is laminated on a substrate 12 having a conductive surface 12a.

There is not any special restriction on a type or a dimensional shape of the substrate 12 as long as the substrate can support at least the metal oxide layer 14. For example, a plate-like or sheet-like substrate is preferably used. In addition to a glass substrate, examples of the substrate include a plastic substrate of polyethylene terephthalate, polyethylene, polypropylene or polystyrene, a metal substrate, an alloy substrate, a ceramic substrate, and a laminated substrate thereof. The substrate 12 preferably has an optical transparency, and more preferably has an excellent optical transparency in a visible light range. Furthermore, the substrate 12 preferably has flexibility. In this case, various configurations of structures can be provided taking advantage of the flexibility.

Moreover, there is not any special restriction on a technique for imparting conductivity to the surface of the substrate 12 to form the conductive surface 12a, and examples of the technique include a method using the substrate 12 having the conductivity, and a method to form a transparent conductive film on the substrate 12 as in a conductive PET film. There is not any special restriction on the latter transparent conductive film, but it is preferable to use FTO obtained by doping $SnO_2$ with fluorine, in addition to ITO, $SnO_2$ and $InO_3$. There is not any special restriction on a method for forming such a transparent conductive film, and a known technique such as an evaporation process, a CVD process, a spray process, a spin coat process or an immersion process can be applied. A thickness of the film can appropriately be set.

Furthermore, as shown in the drawing, an intermediate layer 13 may be provided between the conductive surface 12a and the metal oxide layer 14. The intermediate layer 13 preferably has an optical transparency, and further preferably has conductivity. There is not any special restriction on a material of the intermediate layer 13, and examples of the material include zinc oxide, and the metal oxide for use in the transparent conductive film described above.

The metal oxide layer 14 is a composite structure in which a dye is supported on a porous semiconductor layer substantially constituted of zinc oxide. Here, "substantially constituted of zinc oxide" means that zinc oxide is a main component. The layer may include zinc oxide having a composition ratio different from that of strictly stoichiometric zinc oxide (ZnO). The layer may contain, for example, zinc hydroxide as an unavoidable component, a slight amount of unavoidable impurities such as another metal salt and hydrate and the like. It is to be noted that stoichiometry of "zinc oxide" in the present invention is not limited to ZnO ($Zn_xO_y$, in which $x = 1$, $y = 1$).

The metal oxide layer 14 has a specific surface area of 70 to 250 $m^2/g$ and a void ratio of 50 to 75%. The metal oxide layer 14 includes a specific structure which satisfies such a relation both the specific surface area and the void ratio, whereby a dye replacement property is remarkably improved, and desorption of the co-adsorbed dye and re-adsorption of another dye described later are efficiently performed. In consequence, a sufficient amount of highly sensitive sensitizing dye can be supported.

On the other hand, when the specific surface area of the metal oxide layer 14 is smaller than 70 ($m^2/g$), the amount of the dye to be supported is insufficient, so that the photoelectric conversion efficiency lowers. When the area is larger than 250 ($m^2/g$), a film density excessively lowers, and electron conductivity is insufficient. In consequence, the photoelectric conversion efficiency lowers, and a film strength of the metal oxide layer 14 also lowers. On the other hand, when the void ratio of the metal oxide layer 14 is smaller than 50%, permeability of the electrolyte becomes insufficient, and hence the photoelectric conversion efficiency lowers. When the ratio is larger than 75%, a film density excessively lowers, and electron conductivity becomes insufficient. Therefore, the photoelectric conversion efficiency lowers, and the film strength of the metal oxide layer 14 lowers. Therefore, in a case where the electrode is used in manufacturing a dye-sensitized solar cell by use of the electrolyte, from viewpoints of increase of the film strength and electrolyte permeability and improvement of various cell characteristics, as described above, it is especially preferable that the specific surface area is set to 70 to 150 $m^2/g$ and that the void ratio is set to 55 to 75%.

There is not any special restriction on the sensitizing dye (the dye) to be supported on the metal oxide layer 14, and the dye may be a water-soluble dye, a water-insoluble dye or an oil-soluble dye. From a viewpoint that an amount of the dye to be supported be increased, the dye preferably has an anchor group(s) which interacts with zinc oxide. Specific examples of the dye include xanthein-based dyes such as eosin-Y, coumarin-based dyes, triphenyl methane-based dyes, cyanine-based dyes, merocyanine-based dyes, phthalocyanine-based dyes, porphyrin-based dyes, and polypyridine metal complex dyes. In addition, the examples include ruthenium bipyridium-based dyes, azo dyes, quinone-based dyes, quinonimine-based dyes, quinacridone-based dyes, squarium-based dyes, perylene-based dyes, indigo-based dyes, and naphthalocyanine-based dyes, which have carboxylic group(s), sulfonic group (s) or phosphoric group (s).

Among these dyes, from a viewpoint of further improving the photoelectric conversion efficiency, the dye is a sensitizing dye in which a molar absorption coefficient $\varepsilon$ in a visible light range measured in a t-BuOH/acetonitrile solution is preferably 20000 $mol^{-1} \cdot L \cdot cm^{-1}$ or more, more preferably 25000 $mol^{-1} \cdot L \cdot cm^{-1}$, especially preferably 50000 $mol^{-1} \cdot L \cdot cm^{-1}$. There is not any special restriction on an upper limit of this molar absorption coefficient $\varepsilon$, but the coefficient is usually about 100000 $mol^{-1} \cdot L \cdot cm^{-1}$.

Moreover, there is not any special restriction on a film thickness of the metal oxide layer 14, but the thickness is preferably 1 to 15 $\mu$m, more preferably 2 to 10$\mu$ m. When this film thickness is less than 1 $\mu$m, the dye is not sufficiently supported, whereby a short-circuit photoelectric current density sometimes disadvantageously tends to lower. When the thickness exceeds 15 $\mu$m, there are disadvantages that the film strength becomes insufficient or that a fill factor lowers.

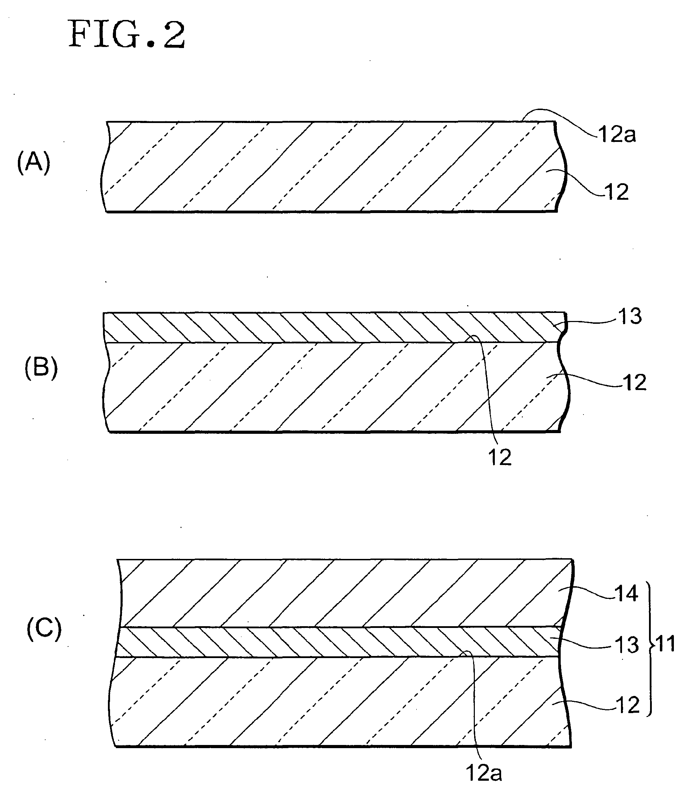

One example of a manufacturing method of the photoelectric conversion electrode 11 of the first embodiment will hereinafter be described. FIGS. 2A to 2C are step diagrams showing that the photoelectric conversion electrode 11 is manufactured. The photoelectric conversion electrode 11 is prepared by a step (FIG. 2A) of preparing the substrate 12, a step (FIG. 2B) of forming the intermediate layer 13 on the substrate 12, and an electrolytic deposition step (FIG. 2C) of forming the metal oxide layer 14 by a cathode electrolytic deposition process.

<Surface Treatment of Substrate>

First, conductivity is imparted to one surface of the substrate 12 by the above-mentioned appropriate method to form the conductive surface 12a (FIG. 2A). It is to be noted that when the substrate 12 beforehand having the conductivity, for example, a metal plate is used as the substrate 12, the step of imparting the conductivity is unnecessary. Subsequently, prior to formation of the intermediate layer 13, the conductive surface 12a of the substrate 12 is subjected to an appropriate surface modification treatment, if necessary. Specific examples of the treatment include a known surface treatment such as a degreasing treatment with a surfactant, an organic solvent or an alkaline aqueous solution, a mechanical polishing treatment, an immersion treatment in an aqueous solution, a preliminary electrolysis treatment with an electrolyte, a washing treatment and a drying treatment.

<Intermediate Layer Forming Step>

The intermediate layer 13 is formed by precipitating or depositing, for example, zinc oxide, the metal oxide for use in the transparent conductive film described above or the like on the conductive surface 12a of the substrate 12 by a known technique such as an evaporation process, a CVD process, a spray process, a spin coat process, an immersion process or an electrolytic deposition process.

<Electrolytic Deposition Step>

Subsequently, the metal oxide layer 14 is formed on the intermediate layer 13 by a cathode electrolytic deposition process. Specifically, the intermediate layer 13 is disposed so as to face a counter electrode in an electrolyte including zinc salt as a metal salt and 80 to 500 $\mu$m of template dye, and a predetermined electrolysis potential is applied between the intermediate layer 13 and the counter electrode by use of a reference electrode according to an ordinary process, whereby a metal oxide is electrolytically deposited on the intermediate layer 13, the template dye is co-adsorbed, and the metal oxide layer 14 is formed by electrolytic deposition (FIG. 2C).

As the electrolyte, an aqueous solution containing zinc salt and having a pH of about 4 to 9 is preferably used. A small amount of an organic solvent may be added to this electrolyte. There is not any special restriction on zinc salt as long as the zinc salt is a zinc ion source capable of supplying zinc ions in the solution. Examples of the zinc salt for preferable use include zinc halides such as zinc chloride, zinc bromide and zinc iodide, zinc nitrate, zinc sulfate, zinc acetate, zinc peroxide, zinc phosphate, zinc pyrophosphate, and zinc carbonate. A zinc ion concentration in the electrolyte is preferably 0.5 to 100 mM, more preferably 2 to 50 mM. An electrolyte prepared by adding, to the above electrolyte, a template dye to be co-adsorbed is preferably used. It is to be noted that when the electrolyte includes zinc halide, an electrolytic deposition reaction of zinc oxide due to reduction of dissolved oxygen in the aqueous solution is promoted, so that oxygen is, for example, bubbled to preferably sufficiently introduce required oxygen. Moreover, a bath temperature of the electrolyte can be set to a broad range in consideration of the thermal resistance of the substrate 12 for use, and the temperature is usually preferably 0 to 100°C, more preferably about 20 to 90°C.

There is not any special restriction on an electrolysis method, and a diode or triode system may be applied. As an energization system, a direct current may be supplied, or a constant potential electrolysis process or a pulse electrolysis process may be used. As the counter electrode, platinum, zinc, gold, silver, graphite or the like may be used according to an ordinary process. Among them, zinc or platinum is preferably used.

A reduction electrolysis potential may appropriately be set in a range of -0.8 to -1.2 V (vs. Ag/AgCl), preferably -0.9 to -1.1 V (vs. Ag/AgCl). The reduction electrolysis potential is in this range, whereby the metal oxide layer 14 including a porous structure having an excellent dye replacement property and a large amount of the dye to be supported can effectively be formed. On the other hand, when the reduction electrolysis potential is above -0.8 V, the film becomes excessively dense, and there is a disadvantage that the amount of the dye to be supported runs short. When the potential is less than -1.2 V, there are disadvantages that the metal oxide becomes more metallic to lower an electric property and that a close contact property of the film deteriorates.

The dye for use as the template dye in this electrolytic deposition step is co-adsorbed by the cathode electrolytic deposition process, so that the dye is preferably dissolved or dispersed in the electrolyte. When an aqueous solution containing zinc salt and having a pH of about 4 to 9 is used as the electrolyte, a water-soluble dye is preferable.

Specifically, from a viewpoint that the amount of the dye to be supported be increased, the template dye preferably has an anchor group(s) which interacts with the surface of zinc oxide, and is preferably a water-soluble dye having anchor group(s) such as a carboxylic group, a sulfonic group or a phosphoric group. More specific examples of the dye include xanthein-based dyes of eosin-Y or the like, coumarin-based dyes, triphenyl methane-based dyes, cyanine-based dyes, merocyanine-based dyes, phthalocyanine-based dyes, porphyrin-based dyes, and polypyridine metal complex dyes.

Moreover, a concentration of the dye in the electrolyte is preferably 80 to 500 $\mu$M, more preferably 100 to 400 $\mu$M. Here, in a case where the dye concentration in the electrolyte exceeds 100 $\mu$M, the metal oxide layer 14 having a specific surface area in excess of 100 $m^2/g$, which has heretofore been difficult to prepare, can easily be prepared.

On the other hand, when the dye concentration in the electrolyte is less than 80 $\mu$M, the film becomes excessively dense to lower the dye replacement property, and the amount of the dye to be supported tends to runs short. When the concentration exceeds 500 $\mu$M, the density of the film excessively lowers, and the electron conductivity lowers, so that the photoelectric conversion efficiency lowers, and the film strength of the metal oxide layer 14 tends to lower.

The metal oxide layer 14 is prepared in this manner, and then preferably subjected to a known post-treatment such as washing, drying and the like according to an ordinary process, if necessary.

The photoelectric conversion electrode 11 obtained in this manner may be used as a photoelectric conversion electrode having an excellent dye replacement property and a large amount of the dye to be supported, or as a precursor of the electrode. It is preferable that the photoelectric conversion electrode 11 is subjected to the following dye desorption treatment and dye re-adsorption treatment in order to further improve the photoelectric conversion efficiency of the electrode.

<Dye Desorption Step>

Here, first of all, the template dye co-adsorbed on the metal oxide layer 14 of the photoelectric conversion electrode 11 is desorbed. Specific examples of this technique include a simple technique to immerse and treat the photoelectric conversion electrode 11 including the template dye in an alkaline aqueous solution containing of sodium hydroxide, potassium hydroxide or the like and having a pH of about 9 to 13. As this alkaline aqueous solution, a heretofore known solution may be used, and can appropriately be selected in accordance with a type of the template dye to be desorbed.

Moreover, in this desorption treatment, it is preferable to desorb preferably 80% or more, more preferably 90% or more of the template dye in the metal oxide layer 14. It is to be noted that there is not any special restriction on an upper limit of a desorption ratio of the template dye, but the upper limit is substantially 99%, because it is actually remarkably difficult to completely desorb the template dye incorporated in zinc oxide crystals. The desorption treatment is preferably performed while heating, because a desorption efficiency can effectively be raised.

Afterward, a greater part of the template dye is desorbed from the photoelectric conversion electrode 11 obtained by performing a known post-treatment such as washing, drying and the like according to an ordinary process if necessary, and the electrode 11 may be used as the precursor of the photoelectric conversion electrode having the excellent dye replacement property and a large latent amount of the dye to be supported.

<Dye Re-adsorption Step>

As described above, a desired sensitizing dye (the second dye) can be re-adsorbed on the metal oxide layer 14 obtained by the desorption treatment of the template dye. Specific examples of this step include a simple technique to immerse the substrate 12 having the metal oxide layer 14 obtained by the desorption treatment of the template dye in a dye-containing solution including the second dye to be re-adsorbed. A solvent of the dye-containing solution for use here can appropriately be selected from known solvents such as water, an ethanol-based solvent and a ketone-based solvent in accordance with solubility, compatibility or the like with respect to the desired sensitizing dye.

As the sensitizing dye to be re-adsorbed, a dye having a desired light absorption band and absorption spectrum can appropriately be selected in accordance with a property required for application to the photoelectric conversion element. According to the treatment of this dye re-adsorption step, the template dye co-adsorbed by the electrolytic deposition step during the formation of the metal oxide layer 14 can be replaced with a dye different from the template dye, and a sensitizing dye more highly sensitive than the template dye is used as the dye, whereby a cell characteristic such as the photoelectric conversion efficiency can be improved.

Here, unlike the template dye beforehand co-adsorbed, the sensitizing dye is not limited in accordance with the type of the electrolyte. Besides the above-mentioned water-soluble dye, for example, a solvent for use in the dye-containing solution is appropriately selected, whereby a water-insoluble and/or oil-soluble dye can be used. In addition to the water-soluble dye exemplified above as the template dye to be co-adsorbed, more specific examples of the sensitizing dye include ruthenium bipyridium-based dyes, azo dyes, quinone-based dyes, quinonimine-based dyes, quinacridone-based dyes, squarium-based dyes, cyanine-based dyes, merocyanine-based dyes, triphenyl methane-based dyes, xanthein-based dyes, porphyrin-based dyes, coumarin-based dyes, phthalocyanine-based dyes, perylene-based dyes, indigo-based dyes, and naphthalocyanine-based dyes. From a viewpoint that the dye be re-adsorbed by the metal oxide layer 14, it is more preferable that the dye has anchor group(s) such as a carboxylic group, a sulfonic group or a phosphoric group which interacts with the surface of zinc oxide.

The photoelectric conversion electrode 11 subsequently subjected to a known post-treatment such as washing, drying and the like according to an ordinary process if necessary is a composite structure in which the sensitizing dye is adsorbed by the surface of zinc oxide, and can preferably be used as a discrete electrode having a large amount of the dye to be supported and further improved photoelectric conversion efficiency, or as the precursor of the electrode.

(Second Embodiment)

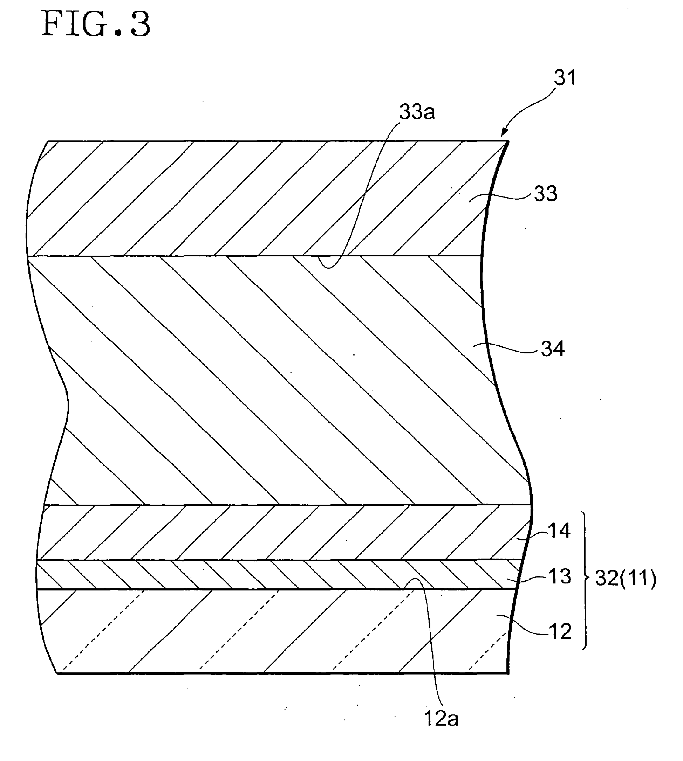

FIG. 3 is a schematic sectional view schematically showing one embodiment of a dye-sensitized solar cell according to the present invention. A dye-sensitized solar cell 31 includes an electrode 11 described above in the first embodiment, as a photoelectric conversion electrode 32, and has a counter electrode 33 disposed so as to face the photoelectric conversion electrode 32, and a charge transport layer 34 disposed between the photoelectric conversion electrode 32 and the counter electrode 33.

The counter electrode 33 is disposed so that a conductive surface 33a of the counter electrode faces a metal oxide layer 14. As the counter electrode 33, a known electrode may appropriately be employed. For example, in the same manner as in a substrate 12 of the photoelectric conversion electrode 11 having a conductive surface 12a, there may be used an electrode having a conductive film on a transparent substrate, an electrode in which a film of a metal, carbon, a conductive polymer or the like is further formed on the conductive film of the transparent substrate or the like.

As the charge transport layer 34, a layer usually for use in a cell, a solar cell or the like may appropriately be used. For example, there may be used a redox electrolyte, a semi-solid electrolyte obtained by gelating the redox electrolyte or a film formed of a p-type semiconductor solid hole transport material.

Here, when the solution-based or semi-solid-based charge transport layer 34 is used, according to an ordinary process, the photoelectric conversion electrode 32 is disposed away from the counter electrode 33 via a spacer (not shown) or the like, and a periphery of the arranged electrodes is sealed to define a sealed space, followed by introducing an electrolyte into the space. Examples of a typical electrolyte of the dye-sensitized solar cell include an acetonitrile solution, an ethylene carbonate solution, a propylene carbonate solution, and a mixed solution thereof, which include iodine and iodide or bromine and bromide. Furthermore, a concentration of the electrolyte, various additives and the like can appropriately be set and selected in accordance with a required performance. For example, halides, an ammonium compound or the like may be added.

[Examples]

The present invention will hereinafter be described in detail with respect to examples, but the present invention is not limited to these examples.

(Example 1)

First, as a substrate, a transparent glass substrate (trade name A110U80: manufactured by Asahi Glass Fabric Co., Ltd.) having a transparent conductive film of $SnO_2$ doped with fluorine was prepared, and a lead wire was attached to one end of the transparent conductive film, and connected to an operation pole of a stabilizing power source. Subsequently, the surface of the transparent conductive film and a lead wire connecting portion were covered with a masking tape having an opening with a size of 40 mm x 40 mm, whereby the transparent conductive film was exposed only to the opening to prepare a film-forming portion.

Then, a lead wire was connected to a zinc plate as a counter electrode, and connected to an Ag/AgCl electrode as a reference electrode for reference. Afterward, the film-forming portion of the transparent conductive film of the transparent glass substrate was disposed so as to face the counter electrode, and the reference electrode was disposed in a polypropylene-made container.

Subsequently, an aqueous solution of potassium chloride and zinc chloride was put into the container so that concentrations of them was 0.1 M and 0.005 M, respectively, to prepare an electrolyte, and a bath temperature of the electrolyte was held at 70°C. Then, a reduction electrolysis potential of -1.2 V (vs. Ag/AgCl) was applied to perform cathode electrolytic deposition for five minutes, and zinc oxide was deposited on the film forming portion of the transparent conductive film to form a film of an intermediate layer.

Furthermore, eosin-Y as a template dye was added to an electrolyte similar to that described above so as to obtain a dye concentration of 0.08 mM, thereby preparing the solution (an electrolyte). Then, using the solution (an electrolyte), a reduction electrolysis potential of -1.0 V (vs. Ag/AgCl) was applied to perform cathode electrolytic deposition for 30 minutes, whereby a porous metal oxide layer as a composite structure of zinc oxide and eosin-Y was formed on the intermediate layer to obtain a photoelectric conversion electrode.

Subsequently, the resultant photoelectric conversion electrode was washed, dried, and then immersed in a KOH aqueous solution to desorb eosin-Y as the co-adsorbed dye in the metal oxide layer, followed by performing again washing and drying treatments.

On the other hand, as a dye-containing solution containing a second dye, a t-BuOH/CH$_3$CN solution at a volume ratio of 1:1 containing 0.5 mM of sensitizing dye (D149: manufactured by Mitsubishi Paper Mills, Ltd.) was prepared, and the electrode from which eosin-Y was desorbed was immersed in this dye-containing solution to re-adsorb the sensitizing dye D149 on the metal oxide layer. Afterward, the washing and drying treatments were performed with an acetonitrile solution to obtain a photoelectric conversion electrode of Example 1.

(Examples 2 to 10, Comparative Example 1)

Photoelectric conversion electrodes of Examples 2 to 10 and Comparative Example 1 were obtained in the same manner as in Example 1 except that a template dye, an amount of the dye to be added and a sensitizing dye to be re-adsorbed were changed as shown in Table 1.

[Table 1]

| | Template dye | | Sensitizing dye | |
|---|---|---|---|---|
| | Template dye | Added amount (mM) | Sensitizing dye | Molar absorption coefficient s (mol$^{-1}$•L•cm$^{-1}$) |
| Example 1 | Eosin-Y | 0.08 | D149 | 68700 |
| Example 2 | Eosin-Y | 0.13 | D149 | 68700 |
| Example 3 | Eosin-Y | 0.25 | D149 | 68700 |
| Example 4 | TPPS | 0.10 | D149 | 68700 |
| Example 5 | Mercurochrome | 0.40 | D149 | 68700 |
| Example 6 | Indigo carmine | 0.35 | Indigo carmine | 26000 |
| Example 7 | Eosin-Y | 0.13 | N3 | 14200 |
| Example 8 | Eosin-Y | 0.50 | D149 | 68700 |
| Example 9 | Indigo carmine | 0.20 | D149 | 68700 |
| Example 10 | Naphtholero-S | 0.45 | D149 | 68700 |
| Comparative Example 1 | Eosin-Y | 0.03 | D149 | 68700 |
| *TPPS: tetraphenyl porphin tetrasulfonate | | | | |

[Cell Evaluation]

A dye-sensitized solar cell having a structure similar to that of a dye-sensitized solar cell 31 shown in FIG. 3 was prepared by the following procedure. First, photoelectric conversion electrodes 11 of Examples 1 to 10 and Comparative Example 1 were used as photoelectric conversion electrodes 32. A Pt thin film having a thickness of 100 nm was evaporated and formed on a transparent glass substrate (trade name A110U80: manufactured by Asahi Glass Fabric Co., Ltd.) of a transparent conductive film of $SnO_2$ doped with fluorine, and was used as a counter electrode 33. Then, the photoelectric conversion electrode 32 was brought into close contact with the counter electrode 33 via a spacer having a thickness of 70 $\mu$m. Furthermore, a periphery around these electrodes was sealed with an epoxy resin to define a sealed space, and an electrolyte as a charge transport layer 34 was introduced into the space, whereby the dye-sensitized solar cells were prepared. As the electrolyte, a mixed solution of ethylene carbonate and acetonitrile at a volume ratio of 80:20 containing 0.04 M of iodine and 0.4 M of tetrapropyl ammonium iodide (TPAI) was used.

As cell characteristics of the dye-sensitized solar cells obtained in this manner, a photoelectric conversion efficiency ($\eta$), an open-circuit voltage (Voc), a short-circuit photoelectric current density (Jsc) and a fill factor (FF) were measured with a solar simulator at AM-1.5 (1000 W/m$^2$). These measurement results are shown in Table 2.

[Measurement of Specific Surface Area and Void Ratio]

The above cell characteristics were evaluated, and then first the dye-sensitized solar cells of Examples 1 to 10 and Comparative Example 1 were disassembled to remove the photoelectric conversion electrodes 11, followed by cleaning the electrodes with an acetonitrile solution and allowing the electrodes to dry naturally. Afterward, the photoelectric conversion electrodes were immersed in a KOH aqueous solution (water: ethanol = 1:1) to desorb the sensitizing dyes from the metal oxide layers. Furthermore, the photoelectric conversion electrodes were cleaned with ethanol, and then subjected to a drying treatment at 100°C for one hour and then the metal oxide layers were cut from the photoelectric conversion electrodes, thereby obtaining solid powder.

Then, a surface area and a pore volume of 0.02 g of each solid powder as a sample were measured using a high speed specific surface area and pore diameter distribution measurement device (trade name Autosorb-1: manufactured by QUANTACHROME Co.), and a specific surface area and a void ratio of the sample were calculated based on the above equations (1) and (2). These measurement results are shown in Table 2.

[Table 2]

| | Photoelectric conversion semiconductor layer | | Cell characteristics | | | |
|---|---|---|---|---|---|---|
| | Specific surface area (m$^2$/g) | Void ratio (%) | Short-circuit photoelectric current density Jsc (mA/cm$^2$) | Open-circuit voltage Voc (V) | Fill factor FF | Conversion efficiency $\eta$ (%) |
| Example 1 | 74 | 58 | 11.3 | 0.66 | 0.56 | 4.18 |
| Example 2 | 105 | 66 | 13.8 | 0.64 | 0.61 | 5.39 |
| Example 3 | 145 | 72 | 14.4 | 0.57 | 0.63 | 5.17 |
| Example 4 | 116 | 69 | 14.0 | 0.60 | 0.62 | 5.21 |
| Example 5 | 132 | 70 | 13.8 | 0.61 | 0.63 | 5.30 |
| Example 6 | 142 | 69 | 10.5 | 0.71 | 0.65 | 4.85 |
| Example 7 | 105 | 66 | 7.8 | 0.68 | 0.62 | 3.29 |
| Example 8 | 190 | 79 | 7.7 | 0.55 | 0.42 | 1.78 |
| Example 9 | 121 | 50 | 9.4 | 0.61 | 0.33 | 1.89 |
| Example 10 | 218 | 51 | 5.2 | 0.64 | 0.51 | 1.70 |
| Comparative Example 1 | 67 | 38 | 2.5 | 0.69 | 0.25 | 0.43 |

It has been confirmed from the results shown in Tables 1 and 2 that the metal oxide layer 14 having a specific surface area of 70 to 250 m$^2$/g and a void ratio of 50 to 75% can be prepared using an electrolyte containing 80 to 500 $\mu$M of template dye and that the metal oxide layer 14 having a specific surface area of 70 to 150.m$^2$/g and a void ratio of 55 to 75% can be prepared using an electrolyte containing 80 to 400 $\mu$M of template dye.

On the other hand, it has also been confirmed that when an electrolyte containing a template dye in excess of 100 $\mu$m is used, the metal oxide layer 14 having a specific surface area in excess of 100 $m^2/g$ is obtained, and the metal oxide layer 14 having a specific surface area in excess of 200 $m^2/g$ can further be prepared.

Moreover, it has been confirmed that in Examples 1 to 10 in which the metal oxide layer 14 has a specific surface area of 70 to 250 $m^2/g$ and a void ratio of 50 to 75%, as compared with Comparative.Example 1, a photoelectric conversion efficiency ($\eta$), an open-circuit voltage (Voc), a short-circuit photoelectric current density (Jsc) and a fill factor (FF) are excellent. Above all, it has been found that in Examples 1 to 7 in which the metal oxide layer has a specific surface area of 70 to 150 $m^2/g$ and a void ratio of 55 to 75%, as compared with Examples 8 to 10 of the present invention and Comparative Example 1, remarkable performance improvement can be achieved.

It is to be noted that as described above, the present invention is not limited to the above embodiments and examples, and can appropriately be modified within the scope of the present invention.

As described above, according to a photoelectric conversion electrode, a manufacturing method of the electrode and a dye-sensitized solar cell of the present invention, a high photoelectric conversion efficiency can be realized, and performances of cell characteristics can be improved. Furthermore, the electrode and the cell can easily be manufactured with good reproducibility. In addition, productivity and economical efficiency can be improved, so that the present invention can broadly and effectively be used in a general electrode for a photoelectric conversion element, electronic and electric materials and devices including the electrode, and various apparatuses, equipments and systems including these materials and devices.

**[0079]** [0000] The present application is based on Japanese priority application No. 2007-086271 filed on March 29, 2007, the entire contents of which are hereby incorporated by reference.

**Claims**

1. A photoelectric conversion electrode which comprises:

   a substrate; and
   a metal oxide layer formed on the substrate, including a metal oxide and a dye and having a specific surface area of 70 to 250 $m^2/g$ and a void ratio of 50 to 75%.

2. The photoelectric conversion electrode according to claim 1, wherein the dye is a sensitizing dye in which a molar absorption coefficient $\varepsilon$ in a visible light range measured in a t-BuOH/acetonitrile solution is 20000 $mol^{-1} \cdot L \cdot cm^{-1}$ or more.

3. A dye-sensitized solar cell comprising:

   a photoelectric conversion electrode;
   a counter electrode disposed so as to face the photoelectric conversion electrode; and
   a charge transport layer disposed between the photoelectric conversion electrode and the counter electrode,

   wherein the photoelectric conversion electrode includes a substrate having a conductive surface, and a metal oxide layer formed on the conductive surface, including a metal oxide and a dye and having a specific surface area of 70 to 250 $m^2/g$ and a void ratio of 50 to 75%.

4. A manufacturing method of a photoelectric conversion electrode which comprises:

   a step of preparing a substrate; and
   an electrolytic deposition step of electrolytically depositing a metal oxide and co-adsorbing a template dye by an electrolytic deposition process using an electrolyte containing a metal salt and the template dye to form, on the substrate, a porous metal oxide layer having a specific surface area of 70 to 250 $m^2/g$ and a void ratio of 50 to 75%.

5. The manufacturing method of the photoelectric conversion electrode according to claim 4, wherein the electrolytic deposition step arranges the substrate and a counter electrode in the electrolyte containing 80 to 500 $\mu$M of template dye so that the substrate faces the counter electrode, and applies an electrolysis potential of -0.8 to -1.2 V (vs. Ag/AgCl) between the substrate and the counter electrode to form the metal oxide layer.

**6.** The manufacturing method of the photoelectric conversion electrode according to claim 4 or 5, which further comprises:

a dye desorption step of desorbing the template dye co-adsorbed on the metal oxide layer; and
a dye re-adsorption step of .allowing the metal oxide layer to support a second dye different from the template dye.

**7.** A manufacturing method of a photoelectric conversion semiconductor electrode which comprises:

a step of preparing a substrate; and
an electrolytic deposition step of electrolytically depositing a metal oxide and co-adsorbing a template dye by an electrolytic deposition process using an electrolyte containing a metal salt and the template dye in excess of 100 $\mu$M, to form, on the substrate, a metal oxide layer having a specific surface area in excess of 100 $m^2$/g.

# FIG.1

# FIG.2

(A)

12a
12

(B)

13
12
12

(C)

14
13    11
12
12a

FIG.3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002184476 A
- JP 2004006235 A
- JP 2007086271 A

**Non-patent literature cited in the description**

- **S. PEULON et al.** *J. Electrochem. Soc.,* 1998, vol. 145, 864
- **T. YOSHIDA et al.** *Electrochemistry,* 2002, vol. 70, 470